# EUROPÄISCHE PATENTSCHRIFT

(11) **EP 3 381 202 B1**
(45) Veröffentlichungstag und Bekanntmachung des Hinweises auf die Patenterteilung: **29.12.2021**
(21) Anmeldenummer: 16774929.0
(22) Anmeldetag: 29.09.2016
(51) Int. Cl.: H04R 17/00

(54) **FLEXIBLE MEMS-LEITERPLATTENEINHEIT SOWIE SCHALLWANDLERANORDNUNG**
FLEXIBLE MEMS CIRCUIT BOARD UNIT, AND ELECTROACOUSTIC TRANSDUCER ARRANGEMENT
UNITÉ CARTE DE CIRCUIT IMPRIMÉ MEMS SOUPLE ET ENSEMBLE TRANSDUCTEUR ACOUSTIQUE

(30) Priorität: 01.10.2015 DE 102015116707
(43) Veröffentlichungstag der Anmeldung: 03.10.2018
(73) Patentinhaber: Usound GmbH, 8020 Graz (AT)
(72) Erfinder: RUSCONI CLERICI BELTRAMI, Andrea, 1130 Wien (AT); BOTTONI, Ferruccio, 8020 Graz (AT)
(74) Vertreter: Canzler & Bergmeier Patentanwälte Partnerschaft mbB
(86) Internationale Anmeldenummer: PCT/EP2016/073166
(87) Internationale Veröffentlichungsnummer: WO 2017/055384

(56) Entgegenhaltungen:
- WO-A1-2016/180841
- DE-A1-102013 114 826
- US-A1- 2003 094 697
- US-A1- 2011 051 985
- US-A1- 2011 085 684
- US-A1- 2014 339 657
- US-A1- 2015 071 467

## Beschreibung

Die vorliegende Erfindung betrifft eine MEMS-Leiterplatteneinheit für eine Schallwandleranordnung, insbesondere einen MEMS-Lautsprecher und/oder ein MEMS-Mikrofon, zum Erzeugen und/oder Erfassen von Schallwellen im hörbaren Wellenlängenspektrum mit einer Leiterplatte und einer mehrschichtigen piezoelektrischen Struktur, mittels der eine dafür vorgesehene Membran (22) in Schwingungen versetzbar und/oder Schwingungen der Membran (22) erfassbar sind. Des Weiteren betrifft die Erfindung eine Schallwandleranordnung zum Erzeugen und/oder Erfassen von Schallwellen im hörbaren Wellenlängenspektrum mit einer Membran und einer MEMS-Leiterplatteneinheit, die eine Leiterplatte und eine mehrschichtige piezoelektrische Struktur umfasst, mittels der die Membran in Schwingungen versetzbar und/oder Schwingungen der Membran erfassbar sind.

Derartige Schallwandleranordnungen werden beispielsweise in Mobiltelefonen oder Hörgeräten verbaut. Die Bezeichnung MEMS steht für mikroelektromechanisches System. Ein MEMS-Schallwandler mit einem aus Silizium ausgestalteten Trägersubstrat, einem in dem Trägersubstrat ausgebildeten Hohlraum und einer mehrschichtigen piezoelektrischen Membranstruktur ist beispielsweise aus der DE 10 2013 114 826 A1 bekannt. Der in dieser Druckschrift beschriebene Hohlraum weist zumindest eine Öffnung auf, welche von der mehrschichtigen piezoelektrischen Membranstruktur überspannt ist. In ihrem Randbereich ist die Membranstruktur mit dem Trägersubstrat, das aus Silizium besteht, verbunden, so dass die Membran zur Erzeugung und/oder zum Erfassen von Schallenergie gegenüber dem Trägersubstrat zu schwingen vermag. Ein wesentlicher Nachteil derartiger siliziumbasierter MEMS-Schallwandler sind die sehr hohen Herstellungskosten, da insbesondere das Silizium im Vergleich zu anderen Materialen sehr teuer ist. Zudem sollte die Größe der piezoelektrischen Membranstruktur auf der einen Seite möglichst groß gewählt werden, um einen hohen Schalldruck erzeugen zu können. Auf der anderen Seite sollte die Membranstruktur aufgrund der teuren piezoelektrischen Bestandteile zur Reduktion der Herstellungskosten möglichst klein gewählt werden. Ein weiterer Nachteil besteht darin, dass ein derartiger MEMS-Schallwandler bzw. ein derartiges Siliziumsubstrat in Verbindung mit einer Leiterplatte verwendet wird, die gemeinsam ein relativ großes Bauvolumen aufweisen. Ihr Einsatzgebiet ist dadurch beschränkt, da diese nur in Geräten verbaut werden können, die einen entsprechend großen Einbauraum zur Verfügung stellen.

Aus der US 2003/0094697 A1 ist eine flexible Leiterplatte bekannt, in die ein piezoelektrisches Element eingebettet ist, das als Mikrofon oder Lautsprecher genutzt werden kann.

Aus der US 2011/0051985 A1 ist ein piezoelektrischer MEMS-Lautsprecher mit einer Kolbenmembran bekannt.

Aus der US 2011/085684 A1 ist ein piezoelektrischer Mikrolautsprecher bekannt, der auf einer Leiterplatte montiert werden kann.

In der DE 10 2013 114 826 A1 ist eine piezoelektrische Membranstruktur zum Erzeugen oder Erfassen von Schallwellen bekannt. Die piezoelektrische Membranstruktur weist Aussparungen auf. Die Aussparungen enden an einer Passivierungsschicht der piezoelektrischen Membranstruktur, so dass die piezoelektrische Membranstruktur vollständig geschlossen ist.

Aus der US 2014/0339657 A1, US 2015/0071467 A1 und WO 2016/180841 A1 sind MEMS-Aktuatoren bekannt, die als integrierte Schaltkreise ausgebildet sind und einen Träger mit einer daran angeordneten mehrschichtigen, piezoelektrischen Struktur umfassen.

Aufgabe der vorliegenden Erfindung ist es somit, eine MEMS-Leiterplatteneinheit sowie eine Schallwandleranordnung zu schaffen, die günstig hergestellt werden kann, einen möglichst großen Schalldruck erzeugen kann und/oder sehr kompakt ausgebildet ist.

Die Aufgabe wird gelöst durch eine MEMS-Leiterplatteneinheit und eine Schallwandleranordnung mit den Merkmalen der unabhängigen Patentansprüche.

Vorgeschlagen wird eine MEMS-Leiterplatteneinheit für eine Schallwandleranordnung zum Erzeugen und/oder Erfassen von Schallwellen im hörbaren Wellenlängenspektrum. Die MEMS-Leiterplatteneinheit weist eine Leiterplatte (PCB - "Printed Circuit Board") und eine mehrschichtige piezoelektrische Struktur, insbesondere eine Aktuatorstruktur und/oder Sensorstruktur, auf. Die Struktur ist derart ausgebildet, dass mittels dieser eine dafür vorgesehene Membran in Schwingungen versetzbar und/oder Schwingungen der Membran erfassbar sind. Die piezoelektrische Struktur ist vorzugsweise als MEMS-Aktuator und/oder MEMS-Sensor ausgebildet. Die Struktur, insbesondere ein zentraler Bereich dieser, ist demnach entlang einer Hubachse auslenkbar, um die dafür vorgesehene Membran in Schwingung zu versetzen oder deren Schwingungen zu erfassen.

Erfindungsgemäß ist die mehrschichtige piezoelektrische Struktur unmittelbar mit der Leiterplatte verbunden, wobei die mehrschichtige piezoelektrische Struktur in die Leiterplatte eingebettet ist. Wenn die Struktur in die Leiterplatte eingebettet ist, sind zumindest Teilbereiche bzw. Abschnitte der Struktur, vorzugsweise zumindest ein Ankerbereich, vollständig, d.h. zumindest an ihrer Ober- und Unterseite, von der Leiterplatte umschlossen. Hierdurch kann das teure Siliziumsubstrat, das bei aus dem Stand der Technik bekannten MEMS-Schallwandlern verwendet wird, eingespart werden. Hierdurch können die Herstellungskosten der MEMS-Leiterplatteneinheit stark reduziert werden. Des Weiteren ist die empfindliche mehrschichtige piezoelektrische Struktur durch das Einbetten in der Leiterplatte vor externen Einflüssen geschützt. Damit die Struktur zur Interaktion mit der dafür vorgesehenen Membran weiterhin entlang der Hubachse ausgelenkt werden kann, ist die Leiterplatte ferner flexibel ausgebildet. Dadurch, dass zur Aufhängung der Struktur unmittelbar die Leiterplatte verwendet wird, kann die MEMS-Leiterplatteneinheit ferner sehr kompakt ausgebildet werden. So kann ein bislang im Stand der Technik verwendetes Zusatzbauteil, insbesondere der Siliziumrahmen, eingespart werden, so dass vor allem die Bauhöhe der MEMS-Leiterplatteneinheit stark reduziert werden kann.

Um eine flexible Ausgestaltung der Leiterplatte zu realisieren, ist es vorteilhaft, wenn auf die Verwendung von Faserverbundmaterialien verzichtet wird. Stattdessen ist der Grundkörper der Leiterplatte vorzugsweise durch ein, insbesondere flexibles, Polymermaterial ausgebildet. Die Verwendung von Polymeren stellt eine entsprechende flexible Ausgestaltung der Leiterplatte sicher. Ferner ist bei Polymeren der Kostenaufwand im Vergleich zu Silizium geringer, sodass eine kostenreduzierte Herstellung der MEMS-Leiterplatteneinheit erreicht werden kann. Auch ist das Herstellungsverfahren einer derartigen flexiblen bzw. biegsamen Leiterplatte - bei dem mehrere Schichten (insbesondere zumindest eine Piezoschicht, eine Tragschicht, eine Elektrodenschicht und/oder mehrere den Grundkörper der Leiterplatte bildende Polymerschichten) durch Lamination miteinander verbunden werden - im Vergleich zu bisher bekannten Herstellungsverfahren deutlich günstiger.

Vorteilhaft ist es, wenn die Struktur zumindest eine piezoelektrische Schicht umfasst, die im Folgenden als Piezoschicht bezeichnet wird. Hierbei kann es sich um eine MEMS-Aktuatorschicht und/oder MEMS-Sensorschicht handeln. Alternativ oder zusätzlich umfasst die Struktur, mindestens eine Elektrodenschicht. Ebenfalls kann die Struktur eine Tragschicht umfassen, die der Struktur die nötige Festigkeit verleiht, um ohne Beschädigung entlang der Hubachse ausgelenkt zu werden.

Vorteilhaft ist es, wenn die mehrschichtige Struktur zwei piezoelektrische Schichten aufweist. Diese sind vorzugsweise jeweils zwischen zwei Elektrodenschichten angeordnet. Hierbei kann eine der, insbesondere vier Elektrodenschichten, durch die Tragschicht ausgebildet sein. Die Tragschicht besteht hierfür vorzugsweise aus einem Metall, insbesondere Kupfer. Wenn die Struktur mehrere piezoelektrische Schichten aufweist, kann die Struktur mehr Kraft erzeugen und eine größere Auslenkung bewirken. Diesbezüglich ist es ferner vorteilhaft, wenn die Struktur mehr als zwei piezoelektrische Schichten aufweist.

Vorteilhaft ist es, wenn eine Piezoschicht der Struktur als Sensor und eine andere Piezoschicht als Aktuator ausgebildet ist. Alternativ kann auch eine Piezoschicht mehrere voneinander getrennte Bereiche umfassen, von denen ein Bereich als Sensor und ein anderer Bereich als Aktuator ausgebildet ist.

Wie bereits vorstehend erwähnt, ist die mehrschichtige Struktur in die Leiterplatte integriert. Zusätzlich ist es von Vorteil, wenn eine Steuereinheit, insbesondere ein ASIC, in die Leiterplatte integriert ist. Der ASIC ist ein elektronischer anwendungsspezifischer integrierter Schaltkreis (englisch: applicationspecific integrated circuit), der geeignet ist, die Schallwandleranordnung zu betreiben. Alternativ oder zusätzlich ist es ebenfalls von Vorteil, zumindest eine passive elektronische Zusatzkomponente in die Leiterplatte zu integrieren. Elektrische, insbesondere passive, Zusatzkomponenten können beispielsweise elektrische Widerstände und/oder E/A-Kontakte sein. Das Bauvolumen der MEMS-Leiterplatteneinheit kann hierdurch sehr gut ausgenutzt werden, wodurch die MEMS-Leiterplatteneinheit wiederum sehr kompakt ausgebildet werden kann.

Vorteilhaft ist es, wenn die Leiterplatte, insbesondere durch Lamination, aus mehreren Schichten, insbesondere mehrerer Polymer-Schichten und/oder Metall-Schichten, hergestellt ist. Durch eine mehrschichtige Ausgestaltung der Leiterplatte können Bauteile, insbesondere die Struktur, der ASIC und/oder zumindest eine passive Zusatzkomponente, einfach und kostengünstig in die Leiterplatte integriert, eingebettet und/oder vollständig gekapselt werden.

Ebenso ist es vorteilhaft, wenn die mehrschichtige piezoelektrische Struktur, wie bereits vorstehend erwähnt, zumindest eine Tragschicht aufweist. Vorzugsweise ist die Tragschicht der Struktur durch eine Schicht der Leiterplatte ausgebildet. Diese Schicht ist somit sowohl Bestandteil der Leiterplatte als auch der Struktur. Die Tragschicht ist vorzugsweise aus einem Metall, insbesondere aus Kupfer, ausgebildet und/oder weist vorzugsweise eine Dicke zwischen 2 bis 50 µm auf. Die Tragschicht kann, insbesondere mittels eines leitfähigen Klebers, mit der Piezoschicht elektrisch gekoppelt sein. In diesem Fall kann die Tragschicht eine Elektrodenschicht zum Ansteuern der Piezoschicht bilden bzw. als solche wirken. Alternativ kann die Tragschicht von der Piezoschicht aber auch, insbesondere mittels einer zwischen diesen beiden angeordneten Isolierschicht, elektrisch voneinander entkoppelt sein.

Vorteilhaft ist es, wenn die Struktur mehrere Piezoschichten aufweist. Die Piezoschichten können derart ausgebildet sein, dass diese jeweils über eine untere und/oder obere Elektrodenschicht angeregt werden können. Des Weiteren ist es denkbar, dass eine der Piezoschichten mit der Tragschicht elektrisch gekoppelt ist und demnach als eine Elektrodenschicht wirkt. Mittels einer derartigen Kopplung kann die Tragschicht direkt an der piezoelektrischen Schicht angeordnet sein. Alternativ befindet sich die Piezoschicht zwischen zwei Elektrodenschichten und/oder ist mittels einer Isolierungsschicht von der Tragschicht elektrisch entkoppelt.

Es ist vorteilhaft, wenn die Struktur gegenüber einem Ankerbereich der Leiterplatte entlang der Hubachse auslenkbar ist und/oder über zumindest ein flexibles Verbindungselement mit einem Befestigungsbereich verbunden ist. In dem Befestigungsbereich der Struktur kann ein Koppelelement angeordnet werden. Mittels des Koppelelements sind die dafür vorgesehene Membran und die Struktur mechanisch miteinander verbunden. Bei elektrischer Anregung der Struktur schwingt das Koppelement infolgedessen zusammen mit der Membran und der Struktur entlang der Hubachse. Vorteilhafterweise können die Membran und die Struktur durch diese räumliche Entkopplung im Wesentlichen unabhängig voneinander, insbesondere geometrisch in Bezug auf ihre jeweilige Größe, optimiert werden, ohne dass hierdurch die Eigenschaften des anderen Bauteils negativ beeinflusst werden. Demnach kann beispielsweise die Struktur im Vergleich zur Membran kleiner ausgebildet werden, wodurch die Materialkosten reduzierbar sind. Zugleich kann die Membran im Vergleich zu Struktur größer ausgebildet werden, wodurch wiederum die Performance - d.h. die akustische Leistungsfähigkeit - erhöht werden kann.

Um eine elektrische Verbindung der MEMS-Leiterplatteneinheit mit einer zweiten Komponente der Schallwandleranordnung, insbesondere mit einer starren zweiten Leiterplatteneinheit zu realisieren, ist es vorteilhaft, wenn die Leiterplatte zumindest einen elektrischen Kontakt aufweist. Mittels eines derartigen internen Kontakts, insbesondere Innenkontakts, kann die MEMS-Leiterplatteneinheit, insbesondere die metallische Tragschicht und/oder zumindest eine Elektrodenschicht, mit der starren zweiten Leiterplatteneinheit, insbesondere mit darin eingebetteten elektronischen aktiven und/oder passiven Komponenten, verbunden werden.

Ebenso ist es vorteilhaft, wenn die Leiterplatte zumindest einen Außenkontakt zum elektrischen Verbinden der MEMS-Leiterplatteneinheit mit einer externen Vorrichtung aufweist. Der Außenkontakt bildet demnach die Schnittstelle zu einer Komponente eines Hauptgerätes, insbesondere eines Hörgerätes und/oder Mobiltelefons.

Vorteilhaft ist es, wenn die Leiterplatte gewebte Kontaktbahnen umfasst, die von der Struktur zu einem elektrischen Kontakt, insbesondere zum Außenkontakt, führen. Vorzugsweise sind im Knick-Biegebereich ausschließlich gewebte Kontaktbahnen angeordnet, d.h. insbesondere nicht die Struktur.

Vorteilhaft ist es, wenn die MEMS-Leiterplatteneinheit einen Kontaktbereich, einen Knick- und/oder Biegebereich und/oder einen Hauptbereich aufweisen. Der Hauptbereich umfasst vorzugsweise die Struktur, das zumindest eine flexible Verbindungselement und/oder den Befestigungsbereich. Der Kontaktbereich umfasst vorzugsweise zumindest einen Außenkontakt. Der Knick-/Biegebereich ist vorzugsweise zwischen dem Hauptbereich und dem Kontaktbereich angeordnet und/oder elastischer als der Hauptbereich ausgebildet. Ferner kann die MEMS-Leiterplatteneinheit in diesem vorzugsweise um bis zu 90° gebogen werden. Eine derartige elastische Ausbildung des Knick-/Biegebereichs kann dadurch sichergestellt werden, wenn nur gewebte, flexible Kontaktbahnen in dem Knick-/Biegebereich angeordnet sind und/oder die Struktur sich vom Hauptbereich ausgehend nicht bis in den Knick-/Biegebereich hineinerstreckt. Durch ein entsprechendes Umknicken und/oder Umbiegen des Kontaktbereiches können die Außenkontakte demnach auch seitlich an der MEMS-Leiterplatteneinheit angeordnet werden.

Um eine Flexibilität der MEMS-Leiterplatteneinheit zu erreichen, ist es vorteilhaft, wenn als Basismaterial für die Leiterplatte ein Polymer verwendet wird. Zusätzlich umfasst die Leiterplatte die vorstehend erwähnte metallische Tragschicht und/oder die gewebten elastischen Kontaktbahnen, insbesondere aus gewebten Kohlenstofffasern oder aus gewebten Metallbahnen. Durch eine derartige elastische Kontaktierung der Elektroden der Schallwandleranordnung werden die Dauerfestigkeitseigenschaften verbessert. Ebenso kann mittels der Verwendung von gewebten Kontaktbahnen gewährleistet werden, dass die MEMS-Leiterplatteneinheit elastisch bleibt und eine hohe Lebensdauer aufweist. Ferner kann hierdurch insbesondere im Knick-/Biegebereich ein großer maximaler Biegewinkel erzielt werden.

Die MEMS-Leiterplatteneinheit, nämlich die Leiterplatte und vorzugsweise die Struktur, weist zumindest eine Ausnehmung auf. Die zumindest eine Ausnehmung ist derart ausgebildet, dass die Struktur, das zumindest eine flexible Verbindungselement und/oder der Befestigungsbereich - insbesondere in ihren jeweiligen Randbereichen - freigeschnitten sind.

Die Struktur weist vorzugsweise einen Kragarm bzw. Kantilever auf oder ist als ein solcher ausgebildet. Dieser ist vorzugsweise an seinem einen Ende fixiert, wohingegen sein anderes Ende aus einer Neutralstellung entlang der Hubachse auslenkbar ist. Mittels eines vorstehend erwähnten Freischnitts der Struktur und/oder der Leiterplatte muss vorteilhafterweise zum Auslenken der Struktur eine geringere Kraft aufgewendet werden. Des Weiteren kann die Struktur hierdurch stärker ausgelenkt werden, da die Auslenkung durch das Grundmaterial der Leiterplatte, insbesondere durch das Polymer, nicht behindert wird. Hierdurch kann der maximale Hub der Membran und somit auch der maximal erzeugbar Schalldruck erhöht werden.

Vorgeschlagen wird ferner eine Schallwandleranordnung, insbesondere ein MEMS-Lautsprecher, ein MEMS-Mikrofon und/oder einen MEMS-Receiver, zum Erzeugen und/oder Erfassen von Schallwellen im hörbaren Wellenlängenspektrum, die eine Membran und eine MEMS-Leiterplatteneinheit aufweist. Vorzugsweise umfasst die Schallwandleranordnung ferner eine Kavität. Unter der Begrifflichkeit "Kavität" ist ein vorzugsweise geschlossener Hohlraum zu verstehen, der sich an einer Seite der Membran anschließt und mittels dem der Schalldruck verstärkt werden kann. Die MEMS-Leiterplatteneinheit umfasst eine Leiterplatte und eine mehrschichtige piezoelektrische Struktur, mittels der die Membran entlang einer Hubachse in Schwingungen versetzbar und/oder Schwingungen der Membran erfassbar sind. Die MEMS-Leiterplatteneinheit ist gemäß der vorangegangenen Beschreibung ausgebildet, wobei die genannten Merkmale einzeln oder in beliebiger Kombination vorhanden sein können. Hierdurch kann die Leiterplatteneinheit sehr kompakt und kostengünstig hergestellt werden. Des Weiteren sind die bewegten sensiblen Komponenten, insbesondere die Struktur, vor äußeren Einflüssen geschützt.

Vorteilhaft ist es, wenn die Schallwandleranordnung eine mit der flexiblen ersten MEMS-Leiterplatteneinheit verbundene zweite Leiterplatteneinheit umfasst, die vorzugsweise starr ausgebildet ist und/oder in dieser zumindest eine elektronische Komponente integriert, insbesondere vollständig eingebettet und/oder eingekapselt, ist. Die zweite Leiterplatteneinheit bildet vorzugsweise den Tragrahmen für die flexible erste MEMS-Leiterplatteneinheit mit ihrer darin eingebetteten piezoelektrischen Struktur. Die zweite starre Leiterplatteneinheit, insbesondere deren Grundkörper, ist vorzugsweise aus einem Faserverbundwerkstoff hergestellt.

Vorteilhaft ist es, wenn die zweite starre Leiterplatteneinheit eine, vorzugsweise zumindest teilweise die Kavität ausbildende, Aussparung aufweist, an deren Öffnung die erste flexible MEMS-Leiterplatteneinheit angeordnet ist. Hierdurch kann die flexible MEMS-Leiterplatteneinheit, insbesondere deren eingebettete Struktur, gegenüber der als Tragrahmen wirkenden zweiten Leiterplatteneinheit entlang der Hubachse schwingen.

Des Weiteren ist es vorteilhaft, wenn sich die Aussparung vollständig durch die zweite starre Leiterplatteneinheit bzw. Leiterplatte erstreckt und/oder im Bereich einer zweiten Öffnung der Aussparung zur Ausbildung einer geschlossenen Kavität ein Gehäuseteil angeordnet ist. Hierdurch kann die Schallwandleranordnung sehr kompakt und kostengünstig ausgebildet werden.

Zur Reduktion der Herstellungskosten ist es vorteilhaft, wenn die Schallwandleranordnung ein Membranmodul umfasst, das die Membran und/oder einen diese in ihrem Randbereich haltenden Membranrahmen umfasst.

Des Weiteren ist es vorteilhaft, wenn die flexible erste MEMS-Leiterplatteneinheit an der dem Membranmodul zugewandten oder abgewandten Seite der starren zweiten Leiterplatteneinheit angeordnet ist. Hierdurch kann beispielsweise die Kavitätsgröße während des Herstellungsprozesses schnell und einfach angepasst werden.

Um die Struktur und die Membran auf ihre jeweiligen individuellen Anforderungen anpassen zu können, ist es vorteilhaft, wenn die Membran über ein Koppelelement mit der flexiblen ersten MEMS-Leiterplatteneinheit, insbesondere in deren Befestigungsbereich, verbunden ist. Das Material des Koppelelements unterscheidet sich vorzugsweise von dem der flexiblen ersten Leiterplatte.

Vorzugsweise ist ein Gehäuse der Schallwandleranordnung durch den Membranrahmen, die zweite starre Leiterplatteneinheit und/oder das die Kavität schließende Gehäuseteil gebildet.

Um eine akustische Anregung des Gehäuseteils vermeiden zu können, ist es vorteilhaft, wenn das Gehäuse aus einem im Vergleich zur Leiterplatte anderem Material, insbesondere einem Metall, einer Keramik und/oder einem Kunststoff, ausgebildet ist.

Vorteilhaft ist es, wenn die erste flexible MEMS-Leiterplatteneinheit mit der starren zweiten Leiterplatteneinheit elektrisch gekoppelt ist, insbesondere mittels eines leitfähigen Klebemittels. Die zweite starre Leiterplatteneinheit weist vorzugsweise elektrische Kontakte auf, wodurch eine elektrische Kontaktierung der ersten mit der zweiten Leiterplatteneinheit erfolgen kann.

Vorteilhaft ist es, wenn zumindest eine elektronische Komponente, wie beispielsweise ein ASIC, in der zweiten starren Leiterplatte integriert, insbesondere vollständig eingekapselt, ist. Alternativ oder zusätzlich kann zumindest eine passive Zusatzkomponente in der zweiten Leiterplatte integriert sein. Durch die Anordnung einer zweiten Leiterplatteneinheit unmittelbar an die erste MEMS-Leiterplatteneinheit ist kein zusätzlicher Trägerrahmen notwendig, wodurch eine kompakte Bauweise realisiert werden kann.

Vorteilhaft ist es, wenn der ASIC, ein durch die Struktur ausgebildeter Sensor und ein durch die Struktur ausgebildeter Aktuator als geschlossener Regelkreis ausgebildet sind.

Weitere Vorteile der Erfindung sind in den nachfolgenden Beispielen und Ausführungsbeispielen beschrieben. Es zeigt:
- **Figur 1**: eine nicht unter die Erfindung fallende MEMS-Leiterplatteneinheit in perspektivischer Darstellung mit einem vollständig geschlossenen und/oder polymeren Grundkörper,
- **Figur 2**: ein zweites Ausführungsbeispiel einer MEMS-Leiterplatteneinheit in einer perspektivischen Darstellung mit einem Kontaktbereich, einem Knick-/Biegebereich sowie einem Hauptbereich,
- **Figur 3**: ein drittes Ausführungsbeispiel einer MEMS-Leiterplatteneinheit in perspektivischer Darstellung bei der die bewegten Komponenten, insbesondere eine Struktur, ein Verbindungselement und/oder ein Befestigungsbereich, freigeschnitten sind,
- **Figur 4**: eine Schnittansicht der in Figur 3 dargestellten MEMS-Leiterplatteneinheit,
- **Figur 5**: ein erstes Ausführungsbeispiel einer Schallwandleranordnung in perspektivischer Darstellung mit zwischen einem Membranmodul und einer zweiten starren Leiterplatteneinheit angeordneter erster MEMS-Leiterplatteneinheit,
- **Figur 6**: eine Schnittansicht des in Figur 5 dargestellten ersten Ausführungsbeispiels der Schallwandleranordnung,
- **Figur 7**: ein zweites Ausführungsbeispiel der Schallwandleranordnung in einer perspektivischen Darstellung mit einer zwischen dem Membranmodul und der ersten flexiblen MEMS-Leiterplatteneinheit angeordneter starren zweiten Leiterplatteneinheit,
- **Figur 8**: eine Schnittansicht des in Figur 7 dargestellten zweiten Ausführungsbeispiels der Schallwandleranordnung,
- **Figur 9**: ein drittes Ausführungsbeispiel der Schallwandleranordnung in einer Schnittansicht, welche die in Figur 2 dargestellte erste MEMS-Leiterplatteneinheit aufweist,
- **Figur 10**: ein viertes Ausführungsbeispiel der Schallwandleranordnung in einer Schnittansicht mit einem Plastikelement, das elektrische Kabelumfasst,
- **Figur 11**: eine Schnittansicht einer mehrschichtigen piezoelektrischen Strukturgemäß einem ersten Ausführungsbeispiel mit einer zwischen einer Tragschicht und einer Elektrodenschicht befindlichen Isolierungsschicht und
- **Figur 12**: eine Schnittansicht der mehrschichtigen piezoelektrischen Strukturgemäß einem zweiten Ausführungsbeispiel mit einer als Elektrodenschicht ausgebildeten Tragschicht.

Bei der nachfolgenden Figurenbeschreibung werden, um die Beziehungen zwischen den verschiedenen Elementen zu definieren, bezugnehmend auf die jeweils in den Figuren dargestellte Lage der Objekte relative Begriffe, wie beispielsweise oberhalb, unterhalb, oben, unten, darüber, darunter, links, rechts, vertikal und horizontal, verwendet. Es versteht sich von selbst, dass sich diese Begrifflichkeiten bei einer Abweichung von der in den Figuren dargestellten Lage der Vorrichtungen und/oder Elemente verändern können. Demnach würde beispielsweise bei einer in Bezug auf die Figuren dargestellten invertierten Orientierung der Vorrichtungen und/oder Elemente ein in der nachfolgenden Figurenbeschreibung als oberhalb spezifiziertes Merkmal nunmehr unterhalb angeordnet sein. Die verwendeten Relativbegriffe dienen somit lediglich zur einfacheren Beschreibung der relativen Beziehungen zwischen den einzelnen im nachfolgenden beschriebenen Vorrichtungen und/oder Elemente.

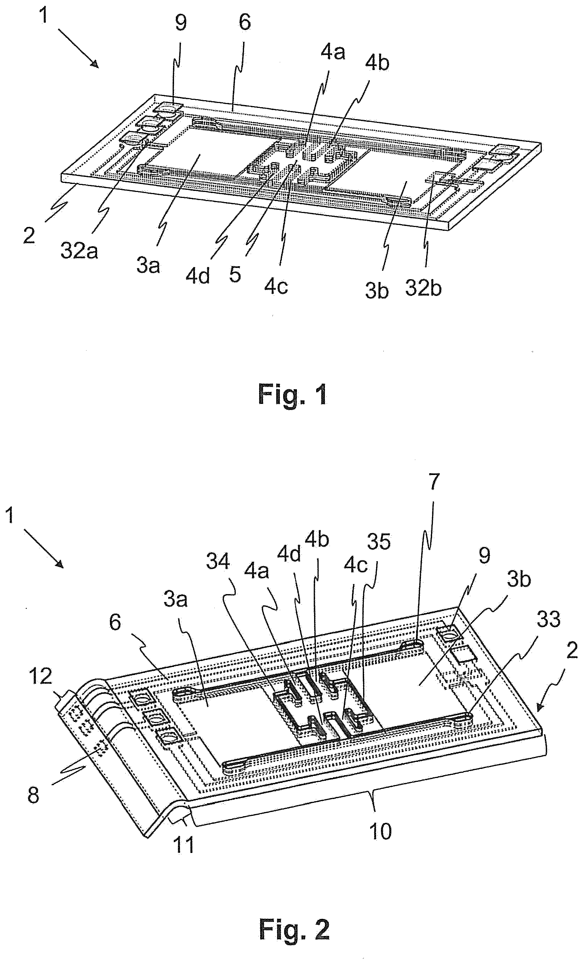

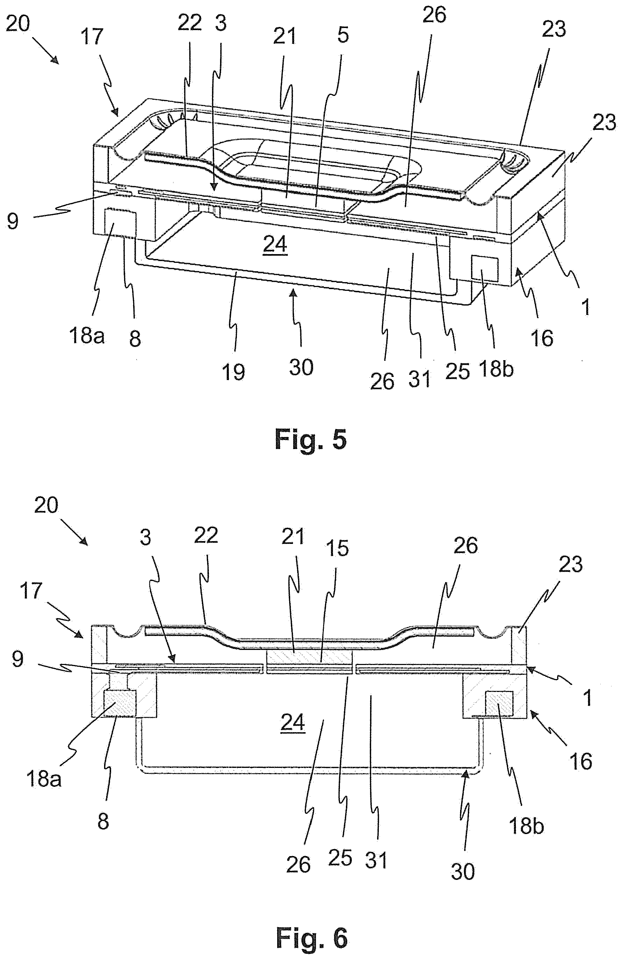

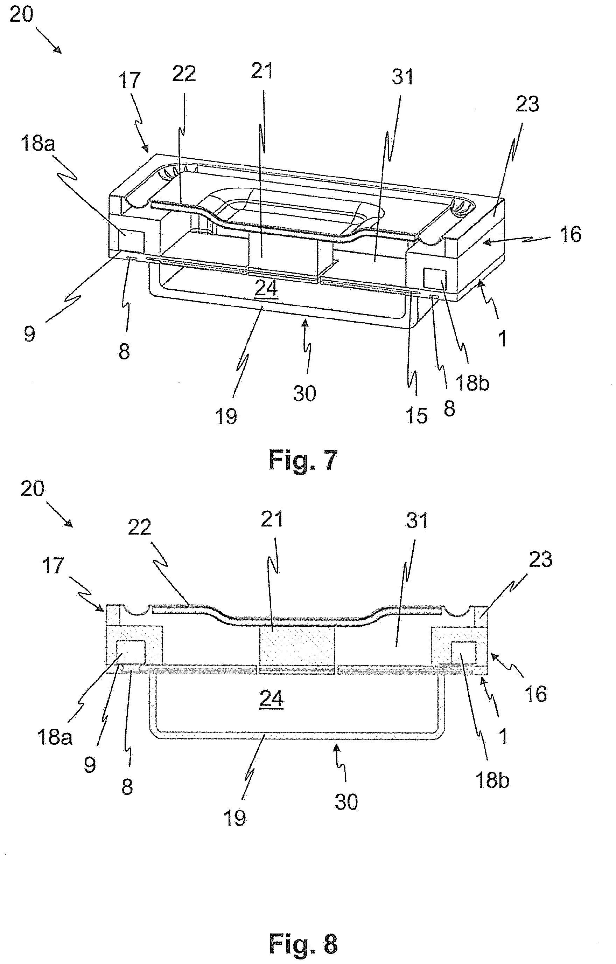

Die Figur 1 zeigt eine nicht unter die Erfindung fallende MEMS-Leiterplatteneinheit 1 in perspektivischer Darstellung. Die MEMS-Leiterplatteneinheit 1 umfasst eine Leiterplatte 2, die als vollständig geschlossener Körper ausgebildet ist. Des Weiteren umfasst die MEMS-Leiterplatteneinheit 1 elektrische Kontakte 9, von denen nur einer mit einem Bezugszeichen versehen ist. Die elektrischen Kontakte 9 befinden sich auf der darstellungsgemäßen Oberseite der Leiterplatte 2 und dienen zur Verbindung der MEMS-Leiterplatteneinheit 1 mit einer beispielsweise in den Figuren 5 und 7 dargestellten zweiten Leiterplatteneinheit 16.

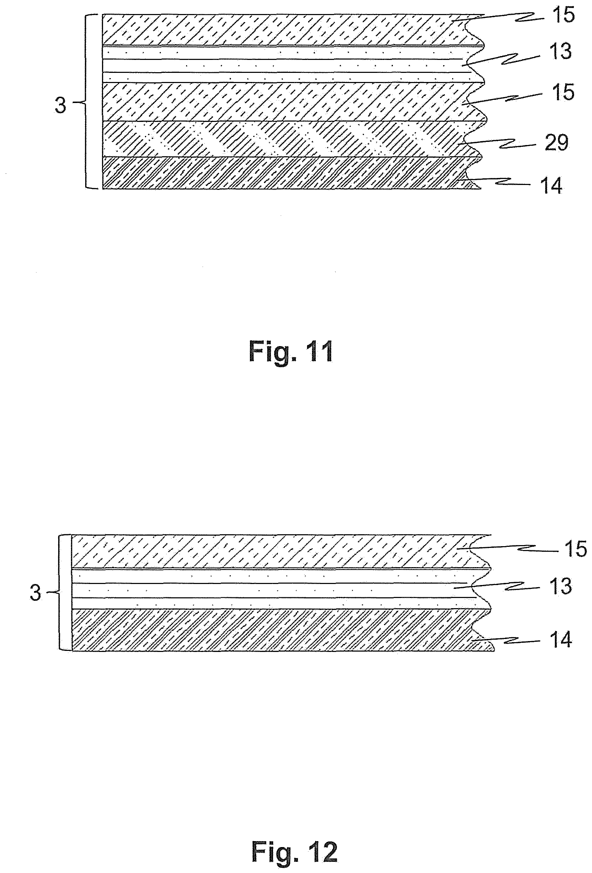

Des Weiteren umfasst die MEMS-Leiterplatteneinheit 1 eine mehrschichtige piezoelektrische Struktur 3. Diese wirkt im Falle eines MEMS-Mikrofons als Sensorstruktur und/oder im Falle eines MEMS-Lautsprechers als Aktuatorstruktur. Eine detaillierte Schnittansicht der piezoelektrischen Struktur 3 ist gemäß zweier unterschiedlicher Ausführungsbeispiele in den Figuren 11 und 12 dargestellt.

Wie in Figur 1 gezeigt, ist die piezoelektrische Struktur 3, mehrere flexible Verbindungselemente 4a, 4b, 4c, 4d und/oder ein Befestigungsbereich 5 vollständig in der Leiterplatte 2 eingekapselt. Die piezoelektrische Struktur 3 ist vorzugsweise als ein MEMS-Aktuator ausgebildet. Die MEMS-Leiterplatteneinheit 1 ist aus einem Polymer hergestellt, sodass diese flexibel ausgestaltbar ist. Des Weiteren umfasst die MEMS-Leiterplatteneinheit 1 flexible, insbesondere gewebte, Kontaktbahnen 6, von denen in den Figuren aus Gründen der Übersichtlichkeit lediglich eine mit einem Bezugszeichen versehen ist.

Die MEMS-Leiterplatteneinheit 1 weist zumindest einen Ankerbereich 32a, 32b auf. Gegenüber diesem kann die als Kragarm oder Kantilever ausgebildete Struktur 3a, 3b entlang einer Hubachse ausgelenkt werden. Vorliegend weist die MEMS-Leiterplatteneinheit 1 gemäß Figur 1 zwei derartige Strukturen 3a, 3b auf. Diese sind jeweils mittels zweier flexibler und/oder elastischer Verbindungselemente 4a - 4d mit dem Befestigungsbereich 5 gekoppelt.

Wenn die Struktur 3 in die Leiterplatte 2 eingebettet ist, sind zumindest Teilbereiche bzw. Abschnitte der Struktur 3, vorzugsweise zumindest der dazugehörige Ankerbereich 32, vollständig, d.h. zumindest an ihrer Oberund Unterseite, von der Leiterplatte 2 umschlossen. Hierdurch kann ein teures Siliziumsubstrat, das gewöhnlich bei aus dem Stand der Technik bekannten MEMS-Schallwandlern verwendet wird, eingespart werden. Hierdurch können die Herstellungskosten der MEMS-Leiterplatteneinheit 1 stark reduziert werden. Des Weiteren ist die empfindliche mehrschichtige piezoelektrische Struktur 3a, 3b durch das Einbetten in der Leiterplatte 2 vor externen Einflüssen geschützt. Damit die Struktur 3a, 3b zur Interaktion mit der beispielsweise in Figur 5 dargestellten Membran 22 weiterhin entlang der Hubachse ausgelenkt werden kann, ist die Leiterplatte 2 ferner flexibel ausgebildet. Dadurch, dass zur Aufhängung der Struktur 3a, 3b unmittelbar die Leiterplatte 2 genutzt wird, kann die MEMS-Leiterplatteneinheit 1 ferner sehr kompakt ausgebildet werden.

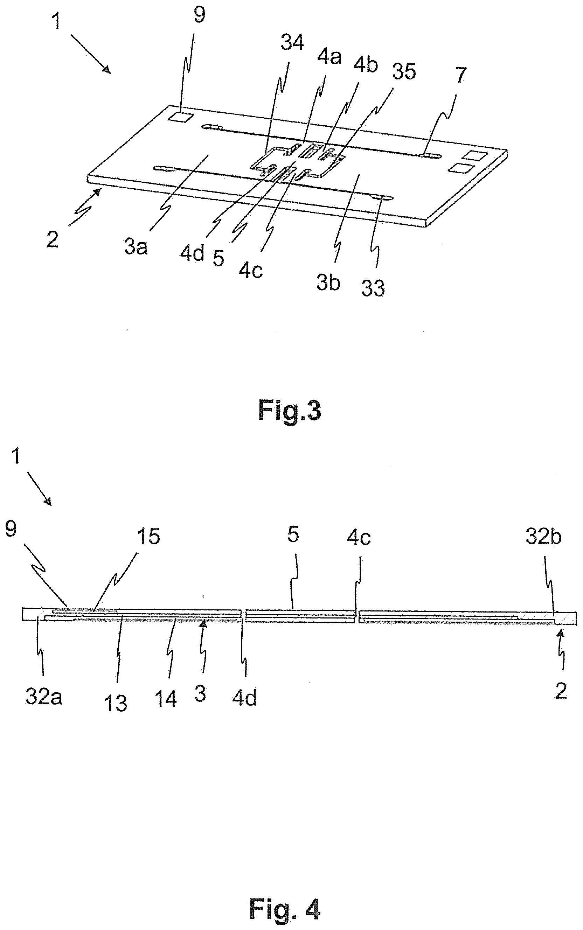

In den Figuren 2 und 3 sind zwei weitere Ausführungsformen der MEMS-Leiterplatteneinheit 1 gezeigt, wobei jeweils im Wesentlichen auf die Unterschiede in Bezug auf die bereits beschriebene Ausführungsform eingegangen wird. So werden bei der nachfolgenden Beschreibung der weiteren Ausführungsformen für gleiche Merkmale gleiche Bezugszeichen verwendet. Sofern diese nicht nochmals detailliert erläutert werden, entspricht deren Ausgestaltung und Wirkweise den vorstehend bereits beschriebenen Merkmalen. Die nachfolgend beschriebenen Unterschiede sind mit den Merkmalen der jeweils vorstehenden und nachfolgenden Ausführungsbeispiele kombinierbar.

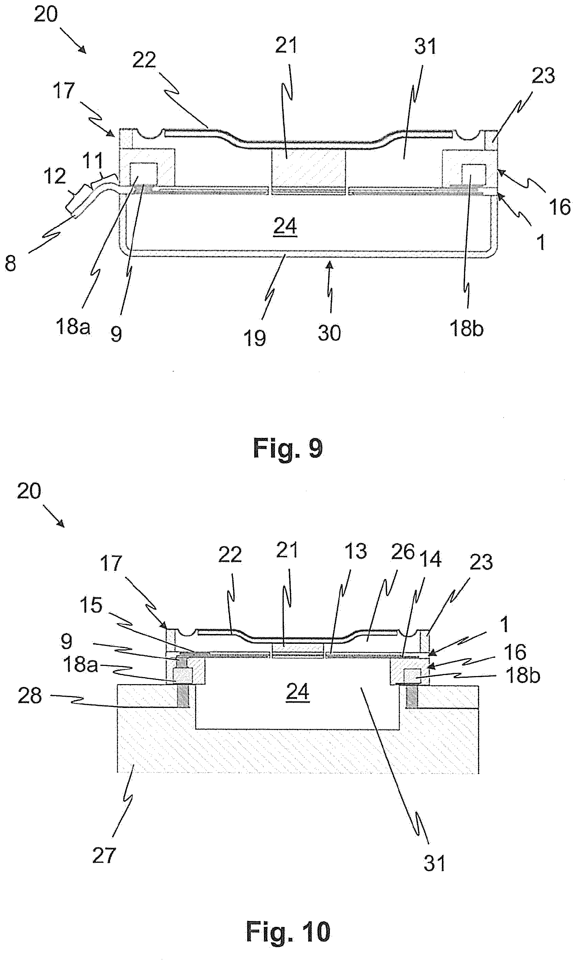

Die in Figur 2 gezeigte MEMS-Leiterplatteneinheit1 umfasst drei Abschnitte bzw. Teilbereiche, nämlich einen Hauptbereich 10, einen Knick-/Biegebereich 11 und einen Kontaktbereich 12. Der Hauptbereich 10 umfasst die sich auf einer Seite der Leiterplatte 2 befindlichen elektrischen Kontakte 9, von denen aus Gründen der Übersichtlichkeit lediglich einer mit einem Bezugszeichen versehen ist. Diese sind dafür vorgesehen, um die MEMS-Leiterplatteneinheit 1 gemäß Figur 9 mit einer zweiten Leiterplatteneinheit 16 elektrisch zu verbinden.

Die Struktur 3a, 3b der MEMS-Leiterplatteneinheit 1 ist gemäß dem in Figur 2 dargestellten Ausführungsbeispiel zumindest teilweise freigeschnitten (gleiches trifft auf das in Figur 3 dargestellt Ausführungsbeispiel zu). Hierfür weist die Leiterplatte 2 zumindest eine durchgängige - d.h. von der Oberseite bis zur Unterseite erstreckende - Ausnehmung 7, 33, 34, 35 auf. Mittels dieser ist die Struktur 3a, 3b zumindest teilweise in ihrem Randbereich freigeschnitten. Vorliegend umfasst die Leiterplatte 2 eine erste Ausnehmung 7 und eine zweite Ausnehmung 33, die die Struktur 3a, 3b, die Verbindungselemente 4a - 4d und/oder den Befestigungsbereich 5 seitlich gegenüber dem als Tragrahmen wirkenden Teil der Leiterplatte 2 freischneiden. Des Weiteren umfasst die Leiterplatte 2 eine dritte und/oder vierte Ausnehmung 34, 35. Mittels dieser ist die jeweilige Struktur 3a, 3b gegenüber den zugeordneten Verbindungselementen 4a - 4d und/oder dem Befestigungsbereich 5 freigeschnitten. Gleiches trifft auf das in Figur 3 und 4 dargestellte Ausführungsbeispiel zu.

Die Struktur 3a, 3b, das mindestens eine flexible Verbindungselement 4a - 4d und der Befestigungsbereich 5 sind somit voneinander und von dem Tragrahmen der Leiterplatte 2 freigeschnitten. Die Ausnehmungen 7, 33, 34, 35 ermöglichen eine kraftreduzierte Auslenkung des Befestigungsbereiches 5. Des Weiteren kann hierdurch ein größerer Hub erzeugt werden. Die gewebten Kontaktbahnen 6 sind im Gegensatz dazu vollständig, d.h. von allen Seiten, in der Leiterplatte 2 integriert.

Der zweite Teilbereich, welcher als Knick-/Biegebereich 11 ausgestaltet ist, befindet sich zwischen dem Kontaktbereich 12 und dem Hauptbereich 10. Der dritte Teilbereich, nämlich der Kontaktbereich 12, weist zumindest einen Außenkontakt 8 zum elektrischen Verbinden der MEMS-Leiterplatteneinheit 1 mit einer externen Vorrichtung (in den Figuren nicht dargestellt) auf. Der Knick-/Biegebereich 11 ist elastischer als der Hauptbereich 10 ausgebildet, sodass vorzugsweise eine Knickung von bis zu 90° möglich ist. Hierdurch können die Außenkontakte 8 gemäß dem in Figur 9 dargestellten Ausführungsbeispiel aus seitlich an einem Gehäuse angeordnet werden. Um eine ausreichende Flexibilität des Knick-Biegebereichs 11 sicherstellen zu können, befinden sich in diesem ausschließlich gewebte Kontaktbahnen 6. Die Struktur 3 erstreckt sich in diesen nicht hinein.

In den Figuren 3 und 4 ist ein weiteres Ausführungsbeispiel der MEMS-Leiterplatteneinheit 1 dargestellt. Bei diesem ist die Struktur 3a, 3b, die Verbindungselemente 4a - 4d und/oder der Befestigungsbereich 5 voneinander und/oder vom Leiterplattenrahmen freigeschnitten, mittels zumindest einer der Ausnehmungen 7, 33, 34, 35. Die Leiterplatte 2 weist ausschließlich an einer Seite, abbildungsgemäß der Oberseite, elektrische Kontakte 9 auf.

Figur 4 zeigt eine Schnittansicht der vorstehend beschriebenen MEMS-Leiterplatteneinheit 1, welche die Leiterplatte 2 und die mehrschichtige piezoelektrische Struktur 3 umfasst. Die Struktur 3 weist gemäß Figur 4 eine Piezoschicht 13, eine, insbesondere metallische, Tragschicht 14 und/oder zumindest eine Elektrodenschicht 15 auf. Die Tragschicht 14 ist gemäß dem vorliegenden Ausführungsbeispiel als eine Elektrodenschicht 15 ausgebildet und direkt mit der Piezoschicht 13 elektrisch gekoppelt. Mittig befindet sich der Befestigungsbereich 5, in dem ein Koppelelement 21 befestigbar ist (vgl. z.B. Figur 6). Die Tragschicht 14 erstreckt sich vorzugsweise zumindest teilweise in den Ankerbereich 32 hinein. Des Weiteren erstreckt sich die Tragschicht 14 vorzugsweise über den gesamten Bereich des Kragarms, der Verbindungselemente 4a - 4d und/oder des Befestigungsbereichs 5. Die Piezoschicht 13 ist im Gegensatz dazu vorzugsweise auf den Bereich des Kragarms beschränkt.

Figur 5 und 6 zeigen ein erstes Ausführungsbeispiel einer Schallwandleranordnung 20. Die Schallwandleranordnung 20 weist ein Gehäuse 30 auf, welches aus einem Membranrahmen 23 eines Membranmoduls 17, der MEMS-Leiterplatteneinheit 1 (das insbesondere gemäß dem in Figur 3 dargestellten Ausführungsbeispiel ausgebildet ist), einer zweiten Leiterplatteneinheit 16 und/oder einem Gehäuseteil 19 ausgebildet ist.

Die zweite Leiterplatteneinheit 16 ist im Gegensatz zur MEMS-Leiterplatteneinheit 1 nicht flexibel, sondern starr ausgebildet. Hierfür ist der Grundkörper der zweiten Leiterplatteneinheit 16 vorzugsweise aus einem Faserverbundwerkstoff ausgebildet. Die zweite Leiterplatteneinheit 16 umfasst eine Aussparung 31. Diese ist durchgängig ausgebildet und erstreckt sich von einer ersten Stirnseite bis zu einer gegenüberliegenden zweiten Stirnseite der zweiten Leiterplatteneinheit 16. Die Aussparung 31 umfasst demnach zwei gegenüberliegende Öffnungen 25, 26. Das Gehäuseteil 19 ist im Bereich einer dieser beiden Öffnungen 26 angeordnet. Das Gehäuseteil 19 schließt demnach die Aussparung 31 zu einer Seite hin ab, wodurch eine Kavität 24 ausgebildet ist.

An der gegenüberliegenden anderen Öffnung 25 der Aussparung 31 ist die flexible MEMS-Leiterplatteneinheit 1 angeordnet. Hierfür ist die MEMS-Leiterplatteneinheit 1 stirnseitig an der starren zweiten Leiterplatteneinheit 16 befestigt. Die starre zweite Leiterplatteneinheit 16 bildet demnach einen starren Tragrahmen für die flexible MEMS-Leiterplatteneinheit 1 aus, gegenüber dem die Struktur 3 den Befestigungsbereich 5 zusammen mit dem Koppelelement 21 entlang der Hubachse auslenken kann.

Wie bereits vorstehend erwähnt, ist die erste MEMS-Leiterplatteneinheit 1 an der ersten Öffnung 25 der Aussparung 31 und das Gehäuseteil 19 an der zweiten Öffnung 26 angeordnet. Das Gehäuseteil 19 verschließt die Aussparung 31 auf Seiten der zweiten Öffnung 26, sodass das Volumen der Kavität 24 durch die Aussparung 31 und den von dem Gehäuseteil 19 gebildeten Teilhohlraum festgelegt ist.

Gemäß dem in Figur 5 und 6 dargestellten Ausführungsbeispiel ist die MEMS-Leiterplatteneinheit 1 zwischen dem Membranmodul 17 und der starren zweiten Leiterplatteinheit 16 angeordnet. Die zweite Leiterplatteneinheit 16, ist mittels elektrischer Kontakte 9 mit der ersten MEMS-Leiterplatteneinheit 1 verbunden. Die Außenkontakte 8 der Schallwandleranordnung 20 sind gemäß dem vorliegenden Ausführungsbeispiel an der zweiten Leiterplatteneinheit 16, insbesondere außerhalb der Kavität 24 und/oder an ihrer der MEMS-Leiterplatteneinheit 16 abgewandten Seite, angeordnet.

Gemäß dem vorliegenden Ausführungsbeispiel ist zumindest eine elektronische Komponente 18a, 18b in der zweiten Leiterplatteneinheit 16 integriert.

Das Membranmodul 17 umfasst neben dem Membranrahmen 23 die Membran 22. Diese ist in ihrem Randbereich in z-Richtung bzw. entlang der Hubachse schwingbar in dem Membranrahmen 23 aufgenommen. Bei elektrischer Anregung der Struktur 3, beginnen das Koppelement 21 zusammen mit der Membran 22 gegenüber der zweiten Leiterplatteneinheit 16 an zu schwingen.

In den Figuren 7, 9 und 10 sind weitere Ausführungsformen der Schallwandleranordnung 20 gezeigt, wobei jeweils im Wesentlichen auf die Unterschiede in Bezug auf die bereits in Figur 5 dargestellte und beschriebene Ausführungsform eingegangen wird. So werden bei der nachfolgenden Beschreibung der weiteren Ausführungsformen für gleiche Merkmale gleiche Bezugszeichen verwendet. Sofern diese nicht nochmals detailliert erläutert werden, entspricht deren Ausgestaltung und/oder Wirkweise den vorstehend bereits beschriebenen Merkmalen. Die nachfolgend beschriebenen Unterschiede können mit den Merkmalen der jeweils vorstehenden und nachfolgenden Ausführungsbeispiele kombiniert werden.

Die Figuren 7 und 8 zeigen eine alternative Schallwandleranordnung 20, die im Wesentlichen gemäß dem vorstehend beschriebenen Ausführungsbeispiel ausgebildet ist. So ist das Gehäuse 30 hierin ebenfalls durch den Membranrahmen 23, der ersten MEMS-Leiterplatteneinheit 1, der zweiten Leiterplatteneinheit 16 und dem Gehäuseteil 19 gebildet. Die zweite Leiterplatteneinheit 16 ist gemäß dem vorliegenden Ausführungsbeispiel jedoch oberhalb der ersten MEMS-Leiterplatteneinheit 1 angeordnet. Die zweite Leiterplatteneinheit ist somit zwischen der ersten MEMS-Leiterplatteneinheit 1 und dem Membranmodul 17 angeordnet. Hierdurch verkleinert sich die Kavität 24 um die Länge der Aussparung 31. Die Außenkontakte sind bei diesem Ausführungsbeispiel an der MEMS-Leiterplatteneinheit 1 ausgebildet, nämlich an der der starren Leiterplatteneinheit 16 abgewandten Seite. Die elektrischen Außenkontakte 8 befinden sich somit auf der Unterseite.

Die Figur 9 zeigt in der Schnittansicht ein weiteres Ausführungsbeispiel der Schallwandleranordnung 20, welche die in Bezug auf Figur 2 beschriebene erste MEMS-Leiterplatteneinheit 1 aufweist. Die zweite Leiterplatteneinheit 16 befindet sich oberhalb der ersten MEMS-Leiterplatteneinheit 1 und somit zwischen dem Membranmodul 17 und der ersten MEMS-Leiterplatteneinheit 1. Das Gehäuse 30 wird aus dem Membranrahmen 23 und der zweiten Leiterplatteneinheit 16 sowie dem Gehäuseteil 19 gebildet. Die elektrischen Komponenten 18, 18a, wie beispielsweise ein ASIC und/oder passive Zusatzkomponente, sind in die zweite Leiterplatteneinheit 16 integriert. Der Kontaktbereich 12 befindet sich außerhalb der Schallwandleranordnung 20 und kann mittels des Knick-/Biegebereichs 11 variabel bewegt werden.

Die Figur 10 zeigt eine Schnittansicht der Schallwandleranordnung 20 gemäß einem weiteren Ausführungsbeispiel. Die Schallwandleranordnung 20 weist ein Plastikelement 27 auf, das im Wesentlichen das Gehäuseteil 19 bildet. In dem Plastikelement 27 befinden sich elektrische Leitungen 28. Die elektrischen Leitungen 28 erstrecken sich seitlich nach außen und dienen als Außenkontakt zum elektrischen Verbinden der Schallwandleranordnung 20 mit einer externen Vorrichtung (in der Figur nicht dargestellt).

Die Figur 11 zeigt eine Schnittansicht der mehrschichtigen piezoelektrischen Struktur 3 gemäß einem ersten Ausführungsbeispiel. Die Struktur 3 umfasst zwei Elektrodenschichten 15 und eine zwischen diesen angeordnete Piezoschicht 13. Des Weiteren ist eine Isolierungsschicht 29 zwischen der Tragschicht 14 und der unteren Elektrodenschicht 15 angeordnet. Die Tragschicht 14 ist mittels der Isolierungsschicht 29 von der unteren Elektrodenschicht 15 elektrisch entkoppelt. Die Tragschicht 14 ist vorzugsweise aus einem Metall, insbesondere Kupfer ausgebildet. Zudem weist die Tragschicht 14 vorzugsweise eine Dicke zwischen 2 bis 50 µm auf.

Die Figur 12 zeigt eine Schnittansicht der mehrschichtigen piezoelektrischen Struktur 3 gemäß einem weiteren Ausführungsbeispiel. Die Struktur 3 umfasst hier eine obere Elektrodenschicht 15, eine als Elektrodenschicht wirkende Tragschicht 14 und eine zwischen diesen beiden angeordnete Piezoschicht 13. Die Tragschicht 14 ist somit mit der Piezoschicht 13 elektrisch gekoppelt. Die Tragschicht 14 ist vorzugsweise aus einem Metall, insbesondere Kupfer, ausgestaltet. Zudem weist die Tragschicht 14 vorzugsweise eine Dicke zwischen 2 bis 50 µm auf.

Die in den Figuren 11 und 12 dargestellten Ausführungsbeispiele der Struktur 3 können in einem hier nicht dargestellten Ausführungsbeispiel zumindest eine weitere piezoelektrische Schicht aufweisen. Diese ist vorzugsweise ebenfalls zwischen zwei ihr zugeordneten Elektrodenschichten angeordnet. Die Struktur 3 würde demnach zwei Piezoschichten 13 umfassen. Hierbei kann eine der, insbesondere vier Elektrodenschichten 15, durch die Tragschicht 14 ausgebildet sein. Die Tragschicht besteht hierfür vorzugsweise aus einem Metall, insbesondere Kupfer. Wenn die Struktur mehrere piezoelektrische Schichten aufweist, kann die Struktur mehr Kraft erzeugen und eine größere Auslenkung bewirken. Diesbezüglich ist es ferner vorteilhaft, wenn die Struktur mehr als zwei derartige Piezoschichten 13 aufweist.

Die vorliegende Erfindung ist nicht auf die dargestellten und beschriebenen Ausführungsbeispiele beschränkt. Abwandlungen im Rahmen der Patentansprüche sind ebenso möglich wie eine Kombination der Merkmale, auch wenn diese in unterschiedlichen Ausführungsbeispielen dargestellt und beschrieben sind.

### Bezugszeichenliste

- 1: MEMS-Leiterplatteneinheit
- 2: Leiterplatte
- 3: mehrschichtige piezoelektrische Struktur
- 4: flexibles Verbindungselement
- 5: Befestigungsbereich
- 6: gewebte Kontaktbahnen
- 7: erste Ausnehmung
- 8: Außenkontakt
- 9: elektrischer Kontakt
- 10: Hauptbereich
- 11: Knick-/Biegebereich
- 12: Kontaktbereich
- 13: Piezoschicht
- 14: Tragschicht
- 15: Elektrodenschicht
- 16: zweite Leiterplatteneinheit
- 17: Membranmodul
- 18: elektronische Komponente
- 19: Gehäuseteil
- 20: Schallwandleranordnung
- 21: Koppelelement
- 22: Membran
- 23: Membranrahmen
- 24: Kavität
- 25: erste Öffnung der Aussparung
- 26: zweite Öffnung der Aussparung
- 27: Plastikelement
- 28: elektrische Leitungen
- 29: Isolierungsschicht
- 30: Gehäuse
- 31: Aussparung
- 32: Ankerbereich
- 33: zweite Ausnehmung
- 34: dritte Ausnehmung
- 35: vierte Ausnehmung

## Patentansprüche

1. MEMS-Leiterplatteneinheit für eine Schallwandleranordnung (20) zum Erzeugen und/oder Erfassen von Schallwellen im hörbaren Wellenlängenspektrum mit
einer Leiterplatte (2) und
einer mehrschichtigen piezoelektrischen Struktur (3), mittels der eine dafür vorgesehene Membran (22) in Schwingungen versetzbar und/oder Schwingungen der Membran (22) erfassbar sind,
wobei die Leiterplatte (2) flexibel ausgebildet ist und
die mehrschichtige piezoelektrische Struktur (3) in der Leiterplatte (2) eingebettet ist,
**dadurch gekennzeichnet,**
**dass** die Leiterplatte (2) zumindest eine durchgängige Ausnehmung (7, 33, 34, 35) aufweist, mittels der die mehrschichtige piezoelektrische Struktur (3) zumindest teilweise in ihrem Randbereich freigeschnitten ist.

2. MEMS-Leiterplatteneinheit nach dem vorherigen Anspruch, **dadurch gekennzeichnet, dass** die mehrschichtige piezoelektrische Struktur (3) eine Aktuator- und/oder Sensorstruktur ist und/oder dass die mehrschichtige piezoelektrische Struktur (3), ein ASIC (18) und/oder zumindest eine passive elektronische Zusatzkomponente (18) in die Leiterplatte (2) integriert und/oder vollständig durch diese gekapselt sind.

3. MEMS-Leiterplatteneinheit nach einem oder mehreren der vorherigen Ansprüche, **dadurch gekennzeichnet, dass** die mehrschichtige piezoelektrische Struktur (3) zumindest eine Tragschicht (14) aus Metall, insbesondere Kupfer, umfasst, welche vorzugsweise eine Dicke zwischen 2 bis 50 µm aufweist.

4. MEMS-Leiterplatteneinheit nach dem vorherigen Anspruch, **dadurch gekennzeichnet, dass** die mehrschichtige piezoelektrische Struktur (3) zumindest eine Piezoschicht (13), insbesondere eine piezoelektrische Aktuatorschicht, aufweist, welche vorzugsweise mit der Tragschicht (14) elektrisch gekoppelt ist, wobei die Tragschicht (14) insbesondere eine Elektrodenschicht (15) bildet, und/oder welche von der Tragschicht (14), insbesondere mittels einer dazwischen angeordneten Isolierschicht (29), elektrisch entkoppelt ist.

5. MEMS-Leiterplatteneinheit nach einem oder mehreren der vorherigen Ansprüche, **dadurch gekennzeichnet, dass** die mehrschichtige piezoelektrische Struktur (3) gegenüber einem Ankerbereich (32) der Leiterplatte (2) auslenkbar ist und/oder, insbesondere über zumindest ein flexibles Verbindungselement (4), mit einem Befestigungsbereich (5), an welchem ein Koppelelement (21) befestigbar ist, verbunden ist.

6. MEMS-Leiterplatteneinheit nach einem oder mehreren der vorherigen Ansprüche, **dadurch gekennzeichnet, dass** die Leiterplatte (2) zumindest einen elektrischen Kontakt (9) zum elektrischen Verbinden der MEMS-Leiterplatteneinheit (1) mit einer zweiten Komponente der Schallwandleranordnung (20), insbesondere einer starren Leiterplatteneinheit (16), aufweist.

7. MEMS-Leiterplatteneinheit nach einem oder mehreren der vorherigen Ansprüche, **dadurch gekennzeichnet, dass** die Leiterplatte (2) zumindest einen Außenkontakt (8) zum elektrischen Verbinden der MEMS-Leiterplatteneinheit (1) mit einer externen Vorrichtung aufweist.

8. MEMS-Leiterplatteneinheit nach einem oder mehreren der vorherigen Ansprüche, **dadurch gekennzeichnet, dass** die Leiterplatte (2) aus einem flexiblen Polymer ausgebildet ist und/oder gewebte elastische Kontaktbahnen (6), insbesondere aus gewebten Kohlenstofffasern oder gewebten Metallbahnen, umfasst.

9. MEMS-Leiterplatteneinheit nach Anspruch 5, **dadurch gekennzeichnet, dass** die MEMSLeiterplatteneinheit (1) einen Hauptbereich (10), in dem vorzugsweise die mehrschichtige piezoelektrische Struktur (3), das zumindest eine flexible Verbindungselement (4) und/oder der Befestigungsbereich (5) angeordnet sind, einen Kontaktbereich (12), in dem vorzugsweise der Außenkontakt (8) angeordnet ist, und/oder einen zwischen diesen beiden angeordneten Knick/Biegebereich (11) aufweist, wobei vorzugsweise der Knick/Biegebereich (11) elastischer als der Hauptbereich (10) ausgebildet ist, nur gewebte Kontaktbahnen (6) umfasst und/oder eine Biegung oder Knickung bis zu 90° ermöglicht.

10. MEMS-Leiterplatteneinheit nach Anspruch 5, **dadurch gekennzeichnet, dass** die MEMS-Leiterplatteneinheit (1) zumindest eine Ausnehmung (7, 33, 34, 35) aufweist, welche vorzugsweise derart ausgebildet ist, dass das zumindest eine flexible Verbindungselement (4) und/oder der Befestigungsbereich (5) in ihren Randbereichen freigeschnitten sind.

11. Schallwandleranordnung zum Erzeugen und/oder Erfassen von Schallwellen im hörbaren Wellenlängenspektrum mit einer Membran (22) und
einer ersten flexiblen MEMS-Leiterplatteneinheit (1),
die eine Leiterplatte (2) und
eine mehrschichtige piezoelektrische Struktur (3) umfasst, mittels der die Membran (22) in Schwingungen versetzbar und/oder Schwingungen der Membran (22) erfassbar sind,
**dadurch gekennzeichnet,**
**dass** die erste flexible MEMS-Leiterplatteneinheit (1) nach einem oder mehreren der vorherigen Ansprüche ausgebildet ist.

12. Schallwandleranordnung nach dem vorherigen Anspruch, **dadurch gekennzeichnet, dass** die Schallwandleranordnung (20) eine Kavität (24) und/oder eine mit der ersten flexiblen MEMS-Leiterplatteneinheit (1) verbundene zweite starr ausgebildete Leiterplatteneinheit (16) umfasst, in der vorzugsweise zumindest eine elektronische Komponente (18) integriert, insbesondere vollständig eingebettet und/oder eingekapselt, ist.

13. Schallwandleranordnung nach dem vorherigen Anspruch 12, **dadurch gekennzeichnet, dass** die zweite starre Leiterplatteneinheit (16) eine, vorzugsweise zumindest teilweise die Kavität (24) ausbildende, Aussparung (31) aufweist, an deren Öffnung die erste flexible MEMSLeiterplatteneinheit (1) angeordnet ist, wobei sich die Aussparung (31) vorzugsweise vollständig durch die zweite starre Leiterplatte (16) erstreckt und/oder im Bereich einer zweiten Öffnung (26) der Aussparung zur Ausbildung einer geschlossenen Kavität (24) ein Gehäuseteil (19) angeordnet ist.

14. Schallwandleranordnung nach einem oder mehreren der vorherigen Ansprüche 12 bis 13, **dadurch gekennzeichnet, dass** die Schallwandleranordnung (20) ein Membranmodul (17) umfasst, das die Membran (22) und/oder einen diese in ihrem Randbereich haltenden Membranrahmen (23) umfasst, und/oder
dass die flexible erste MEMS-Leiterplatteneinheit (1) an der dem Membranmodul (17) zugewandten oder abgewandten Seite der starren zweiten Leiterplatteneinheit (16) angeordnet ist.

15. Schallwandleranordnung nach einem oder mehreren der vorherigen Ansprüche 11 bis 14, **dadurch gekennzeichnet, dass** die Membran (22) über ein Koppelelement (21) mit der flexiblen ersten MEMS-Leiterplatteneinheit (1), insbesondere mit deren Befestigungsbereich (5), verbunden ist.

## Claims

1. MEMS printed circuit board unit for a sound transducer assembly (20) for generating and/or detecting sound waves in the audible wavelength spectrum, with
a printed circuit board (2) and
a multi-layer piezoelectric structure (3), by means of which a membrane (22) provided for this purpose can be set into oscillation and/or oscillations of the membrane (22) can be detected,
wherein the printed circuit board (2) is designed to be flexible and that the multi-layer piezoelectric structure (3) is embedded in the printed circuit board (2),
**characterized in that**
that the printed circuit board (2) has at least one continuous recess (7, 33, 34, 35), by means of which the multi-layer piezoelectric structure (3) is at least partially cut free in its edge region.

2. MEMS printed circuit board unit according to the preceding claim, **characterized in that** the multi-layer piezoelectric structure (3) is an actuator structure and/or a sensor structure, and/or
that the multi-layer piezoelectric structure (3), an ASIC (18) and/or at least one additional passive electronic component (18) are integrated in the printed circuit board (2) and/or are completely encapsulated by it.

3. MEMS printed circuit board unit according to one or more of the preceding claims, **characterized in that** the multi-layer piezoelectric structure (3) comprises at least one support layer (14) made of metal, in particular copper, which preferably features a thickness of between 2 to 50 µm.

4. MEMS printed circuit board unit according to the preceding claim, **characterized in that** the multi-layer piezoelectric structure (3) features at least one piezo layer (13), in particular a piezoelectric actuator layer, which is preferably electrically coupled to the support layer (14), whereas the support layer (14) forms in particular an electrode layer (15), and/or which is electrically decoupled from the support layer (14), in particular by means of an insulating layer (29) arranged between them.

5. MEMS printed circuit board unit according to one or more of the preceding claims, **characterized in that** the multi-layer piezoelectric structure (3) can be deflected relative to an anchor area (32) of the printed circuit board (2), and/or is connected, in particular through at least one flexible connecting element (4), to a fastening area (5), to which a coupling element (21) can be fastened.

6. MEMS printed circuit board unit according to one or more of the preceding claims, **characterized in that** the printed circuit board (2) features at least one electrical contact (9) for electrically connecting the MEMS printed circuit board unit (1) to a second component of the sound transducer assembly (20), in particular a rigid printed circuit board unit (16).

7. MEMS printed circuit board unit according to one or more of the preceding claims, **characterized in that** the printed circuit board (2) features at least one external contact (8) for electrically connecting the MEMS printed circuit board unit (1) to an external device.

8. MEMS printed circuit board unit according to one or more of the preceding claims, **characterized in that** the printed circuit board (2) is formed from a flexible polymer and/or comprises woven elastic contact paths (6), in particular made of woven carbon fibers or of woven metal paths.

9. MEMS printed circuit board unit according to claim 5, **characterized in that** the MEMS printed circuit board unit (1) features a main area (10), in which the multi-layer piezoelectric structure (3), the at least one flexible connecting element (4) and/or the fastening area (5) are preferably arranged, a contact area (12), in which the external contact (8) is preferably arranged, and/or a kinking / bending area (11) arranged between these two, whereas preferably the kinking / bending area (11) is designed to be more elastic than the main area (10),
comprises only woven contact paths (6) and/or enables a bending or kinking up to 90°.

10. MEMS printed circuit board unit according to claim 5, **characterized in that** the MEMS printed circuit board unit (1) features at least one recess (7, 33, 34, 35), which is preferably designed in such a manner that the at least one flexible connecting element (4) and/or the fastening area (5) are cut free, in their edge areas.

11. Sound transducer assembly for generating and/or detecting sound waves in the audible wavelength spectrum with
a membrane (22) and
a first flexible MEMS printed circuit board unit (1),
which comprises a printed circuit board (2) and
a multi-layer piezoelectric structure (3), by means of which the membrane (22) can be set into oscillation and/or oscillations of the membrane (22) can be detected,
**characterized in that**
the first flexible MEMS printed circuit board unit (1) is formed according to one or more of the preceding claims.

12. Sound transducer assembly according to the preceding claim, **characterized in that** the sound transducer assembly (20) comprises a cavity (24) and/or a second rigidly formed printed circuit board unit (16) connected to the first flexible MEMS printed circuit board unit (1),
in which at least one electronic component (18), is preferably integrated (in particular, completely embedded and/or encapsulated).

13. Sound transducer assembly according to the preceding claim 12, **characterized in that** the second rigid printed circuit board unit (16) features a recess (31), preferably at least partially forming the cavity (24), at the opening of which the first flexible MEMS printed circuit board unit (1) is arranged, whereas the recess (31) preferably extends completely through the second rigid printed circuit board (16), and/or a housing part (19) is arranged in the area of a second opening (26) of the recess for forming a closed cavity (24).

14. Sound transducer assembly according to one or more of the preceding claims 12 to 13, **characterized in that** the sound transducer assembly (20) comprises a membrane module (17), which
comprises the membrane (22) and/or a membrane frame (23) holding it in its edge area, and/or
that the flexible first MEMS printed circuit board unit (1) is arranged on the side of the rigid second printed circuit board unit (16) turned towards or turned away from the membrane module (17).

15. Sound transducer assembly according to one or more of the preceding claims 11 to 14, **characterized in that** the membrane (22) is connected through a coupling element (21) to the flexible first MEMS printed circuit board unit (1), in particular by means of its fastening area (5).

## Revendications

1. Unité de carte imprimée MEMS pour un ensemble de transducteur acoustique (20) destiné à générer et/ou à détecter des ondes acoustiques dans le spectre des longueurs d'onde audible, avec une carte imprimée (2) et
une structure piézoélectrique multicouche (3), au moyen de laquelle une membrane (22) prévue à cet effet peut être mise en oscillations et/ou des oscillations de la membrane (22) peuvent être détectées, dans laquelle la carte imprimée (2) se présente sous une forme flexible et
la structure piézoélectrique multicouche (3) est incorporée dans la carte imprimée (2),
**caractérisée en ce que**
la carte imprimée (2) présente au moins un évidement continu (7, 33, 34, 35) au moyen duquel la structure piézoélectrique multicouche (3) est au moins partiellement découpée dans sa zone de bordure.

2. Unité de carte imprimée MEMS selon la revendication précédente, **caractérisée en ce que** la structure piézoélectrique multicouche (3) est une structure d'actionneur et/ou de capteur et/ou en ce que la structure piézoélectrique multicouche (3), un ASIC (18) et/ou au moins un composant électronique supplémentaire passif (18) sont intégrés dans la carte imprimée (2) et/ou complètement encapsulés par celle-ci.

3. Unité de carte imprimée MEMS selon l'une quelconque ou plusieurs des revendications précédentes, **caractérisée en ce que** la structure piézoélectrique multicouche (3) comprend au moins une couche porteuse (14) en métal, en particulier en cuivre, qui présente de préférence une épaisseur de 2 à 50 µm.

4. Unité de carte imprimée MEMS selon la revendication précédente, **caractérisée en ce que** la structure piézoélectrique multicouche (3) présente au moins une couche piézoélectrique (13), en particulier une couche d'actionneur piézoélectrique, qui est de préférence couplée électriquement à la couche porteuse (14), la couche porteuse (14) formant en particulier une couche d'électrode (15), et/ou qui est découplée électriquement de la couche porteuse (14), en particulier au moyen d'une couche isolante (29) disposée entre elles.

5. Unité de carte imprimée MEMS selon l'une quelconque ou plusieurs des revendications précédentes, **caractérisée en ce que** la structure piézoélectrique multicouche (3) peut être déviée par rapport à une zone d'ancrage (32) de la carte imprimée (2) et/ou est reliée, en particulier par l'intermédiaire d'au moins un élément de connexion (4) flexible, à une zone de fixation (5) à laquelle peut être fixé un élément de couplage (21).

6. Unité de carte imprimée MEMS selon l'une quelconque ou plusieurs des revendications précédentes, **caractérisée en ce que** la carte imprimée (2) présente au moins un contact électrique (9) pour connecter électriquement l'unité de carte imprimée MEMS (1) à un deuxième composant de l'ensemble de transducteur acoustique (20), en particulier une unité de carte imprimée (16) rigide.

7. Unité de carte imprimée MEMS selon l'une quelconque ou plusieurs des revendications précédentes, **caractérisée en ce que** la carte imprimée (2) présente au moins un contact extérieur (8) pour connecter électriquement l'unité de carte imprimée MEMS (1) à un dispositif externe.

8. Unité de carte imprimée MEMS selon l'une quelconque ou plusieurs des revendications précédentes, **caractérisée en ce que** la carte imprimée (2) est formée d'un polymère flexible et/ou comprend des pistes de contact (6) élastiques tissées, en particulier en fibres de carbone tissées ou pistes métalliques tissées.

9. Unité de carte imprimée MEMS selon la revendication 5, **caractérisée en ce que** l'unité de carte imprimée MEMS (1) présente une zone principale (10), dans laquelle sont de préférence disposés la structure piézoélectrique multicouche (3), l'au moins un élément de connexion (4) flexible et/ou la zone de fixation (5), une zone de contact (12), dans laquelle est de préférence disposé le contact extérieur (8) et/ou une zone flambée/pliée (11) disposée entre ces deux, la zone flambée/pliée (11) se présentant de préférence sous une forme plus élastique que la zone principale (10),
ne comprend que des pistes de contact (6) tissées et/ou permet un pliage ou un flambage atteignant 90°.

10. Unité de carte imprimée MEMS selon la revendication 5, **caractérisée en ce que** l'unité de carte imprimée MEMS (1) présente au moins un évidement (7, 33, 34, 35) qui se présente de préférence sous une forme telle que l'au moins un élément de connexion (4) flexible et/ou la zone de fixation (5) présente(nt) une découpe libre dans leurs zones de bordure.

11. Ensemble de transducteur acoustique pour générer et/ou détecter des ondes acoustiques dans le spectre de longueur d'onde audible, avec une membrane (22) et
une première unité de carte imprimée MEMS (1) flexible,
qui comprend une carte imprimée (2) et
une structure piézoélectrique multicouche (3), au moyen de laquelle la membrane (22) peut être mise en oscillations et/ou des oscillations de la membrane (22) peuvent être détectées,
**caractérisée en ce que**
la première unité de carte imprimée MEMS (1) flexible se présente sous une forme selon l'une quelconque ou plusieurs des revendications précédentes.

12. Ensemble de transducteur acoustique selon la revendication précédente, **caractérisé en ce que** l'ensemble de transducteur acoustique (20) comprend une cavité (24) et/ou une deuxième unité de carte imprimée (16) se présentant sous une forme rigide et reliée à la première unité de carte imprimée MEMS (1) flexible, dans laquelle, de préférence, au moins un composant électronique (18) est intégré, en particulier complètement incorporé et/ou encapsulé.

13. Ensemble de transducteur acoustique selon la revendication 12 précédente, **caractérisé en ce que** la deuxième unité de carte imprimée (16) rigide présente un évidement (31), formant de préférence au moins partiellement la cavité (24), à l'ouverture duquel est disposée la première unité de carte imprimée MEMS (1) flexible, l'évidement (31) s'étendant de préférence complètement à travers la deuxième carte imprimée (16) rigide et/ou une partie (19) de boîtier étant disposée dans la zone d'une deuxième ouverture (26) de l'évidement pour former une cavité fermée (24).

14. Ensemble de transducteur acoustique selon l'une quelconque ou plusieurs des revendications 12 à 13 précédentes, **caractérisé en ce que** l'ensemble de transducteur acoustique (20) comprend un module de membrane (17) qui
comprend la membrane (22) et/ou un cadre de membrane (23) maintenant celle-ci dans sa zone de bordure, et/ou
**en ce que** la première unité de carte imprimée MEMS (1) flexible est disposée sur le côté de la deuxième unité de carte imprimée (16) rigide qui est orienté vers le module de membrane (17) ou détourné celui-ci.

15. Ensemble de transducteur acoustique selon l'une quelconque ou plusieurs des revendications 11 à 14 précédentes, **caractérisé en ce que** la membrane (22) est reliée à la première unité de carte imprimée MEMS (1) flexible, en particulier à sa zone de fixation (5), par l'intermédiaire d'un élément de couplage (21).
